# EUROPEAN PATENT APPLICATION

(11) **EP 4 831 672 A1**
(43) Date of publication of application: **28.10.2026**
(21) Application number: 25172557.8
(22) Date of filing: 25.04.2025
(51) Int. Cl.: G01R 33/483, G01R 33/50, G01R 33/54, G01R 33/56, G01R 33/563, G01R 33/567

(54) **METHOD FOR OPERATING A MAGNETIC RESONANCE IMAGING DEVICE, MAGNETIC RESONANCE IMAGING DEVICE, COMPUTER PROGRAM AND ELECTRONICALLY STORAGE MEDIUM**

(71) Applicant: Siemens Healthineers AG, 91301 Forchheim (DE); King's College London, London WC2R 2LS (GB)
(72) Inventor: The designation of the inventor has not yet been filed
(74) Representative: Siemens Healthineers Patent Attorneys

(57) **Abstract**

The invention relates to a method for operating a magnetic resonance imaging device a magnetic resonance sequence is used to, in an acquisition volume of a patient, acquire magnetic resonance data in k-space, wherein the magnetic resonance measurement data is acquired in at least two repetitions, the magnetic resonance sequence comprising, for each repetition:
- a preparation module, comprising at least one tip-down radio frequency pulse and at least one tip-up radio frequency pulse applied a preselected preparation time after the tip-down radio frequency pulse, and
- a readout module.

Herein the tip-down radio frequency pulse is slab-selective by applying a first slab selection gradient pulse in a phase-encoding direction, and the preparation module of at least one of the at least two repetitions prepares the magnetisation in the acquisition volume differently than the preparation module in another of the at least two repetitions.

## Description

The invention concerns a method for operating a magnetic resonance imaging device, wherein, for a magnetisation prepared imaging in an acquisition volume of a patient, a magnetic resonance sequence is used to acquire magnetic resonance measurement data in k-space. The invention further concerns a magnetic resonance imaging device, a computer program, and an electronically readable storage medium.

Magnetic resonance techniques (the abbreviation MR stands for magnetic resonance below) are known techniques with which images of the interior of an object under examination can be generated. In simplified terms, the object under examination is for this purpose positioned in a magnetic resonance device in a comparatively strong static, homogeneous constant magnetic field, also called main field, B0, with field strengths of 0.2 tesla to 7 tesla and more, so that its nuclear spins are oriented along the constant magnetic field. To trigger nuclear spin resonances that can be measured as signals, radiofrequency excitation pulses (RF pulses) are irradiated into the object under examination. Thus triggered nuclear spin resonances are measured as measurement data, so-called k-space data, and, based on the measurement data, MR images are reconstructed, or spectroscopy data is determined. For position encoding of the measurement data, rapidly switched magnetic gradient fields, also just called gradients or gradient pulses, are superimposed on the constant magnetic field. A sequence that gives the relations between RF pulses and gradients to be applied, is commonly referred to as a (pulse) sequence (diagram). The acquired measurement data is digitized and stored as complex numerical values in a k-space matrix. An associated MR image can be reconstructed from the k-space matrix populated with values, for example by means of a multidimensional Fourier transform. All measurements to be taken, maybe including multiple pulse sequences, for one examination are often referred to as (examination) protocol.

Magnetic resonance imaging (MRI) is a well-known and often-used medical imaging modality. Different aspects of acquisition volumes in a human or animal body may be the subject of the examination by applying different weightings during imaging. A corresponding magnetic resonance sequence is chosen. "Classical" known and used weightings comprise T1 weighting, T2 weighting, T2* weighting and proton density weighting. As the chosen weightings change the contrast of the resulting image, the weightings are also referred to as contrast (here e.g. T1 contrast, T2 contrast, T2* contrast and proton density contrast).

Diffusion-weighted imaging (DWI) allows acquiring magnetic resonance diffusion data describing the molecular function and micro-architecture of the body and is an important addition to the above-mentioned weightings. In principle, signal contrast is generated based on the difference of Brownian motion of water molecules by measuring the properties of spins of protons bound in water ("water spins"). For example, diffusion coefficient maps, in particular regarding the apparent diffusion coefficient (ADC), can be reconstructed from magnetic resonance diffusion data.

The basic principle of diffusion imaging is to apply symmetric, strong diffusion-sensitizing gradients (often shortly "diffusion gradients") on either side of a 180° refocusing radio frequency pulse after spins have been excited by a tip-down pulse. The phases of stationary spins are not affected by the pair of diffusion gradients. If, however, spins have moved to a different location between the diffusion gradients due to diffusion, they are differently affected and hence fall out of phase, leading to signal loss. After such a diffusion preparation module has been played out, a readout module (acquisition module) is used to acquire the diffusion prepared magnetic resonance measurement data.

Often differently weighted images are acquired to help diagnose a condition of an examination object, particularly a patient. For example, the current standard protocol for suspected prostate cancer MR examinations relies solely on qualitative images, including two-dimensional (2D) T2-weighted turbo spin echo (TSE) and 2D diffusion-weighted single-shot echo-planar imaging (EPI) sequences. However, 2D images have limited resolution in the through-plane direction. Additionally, acquiring two contrasts in separate scans can result in misregistration of anatomy between the two datasets. Also, qualitative imaging is subjective and can limit reproducibility between scans.

Several applications of diffusion weighted imaging, such as for surgical planning, radiotherapy planning and monitoring of treatment response, require accurate geometric fidelity. Conventional diffusion weighted imaging, which uses a diffusion preparation module with diffusion-sensitizing gradients combined with a two-dimensional spin-echo single-shot echo planar imaging (SS-EPI) readout module, suffers from spatial distortions, especially for high resolution acquisitions and at higher main field strengths, for example 3T or more.

A diffusion preparation module has been combined with a turbo spin echo (TSE) or balanced steady-state free precession (bSSFP) readout module for distortion-free diffusion imaging, however, such acquisitions suffer from specific absorption rate (SAR) limitations, especially at high main field strength, for example 3T or above. Diffusion preparation modules have also been combined with low SAR T1 gradient-echo readout modules. However, a relatively long readout duration is required, resulting in increased T1 contamination of the acquired magnetic resonance signal. Furthermore, a robust correction for motion-induced magnitude and phase errors has not been provided in the known gradient echo approaches.

Several different solutions to solve part but not all the limitations named above have been proposed. A three-dimensional (3D) sequence with diffusion preparation is described, e.g. from the article of Dregely et al., "Rapid quantitative T2 mapping of the prostate using three-dimensional dual echo steady state MRI at 3T", Magn. Reason. Med., 76: pp.1720-1729, 2016. The used dual echo steady state (DESS) sequence already allows for a T2 mapping, as does the T2-prepared sequence described in the article of Roccia et al., "Accelerated 3D T2 mapping with dictionary-based matching for prostate imaging", Magn. Reason. Med., 81: pp.1795-1805, 2019. However, these implementations require complex fitting models to generate T2 maps.

It is an object of the present invention to overcome the above-mentioned problems and to provide a magnetisation prepared imaging approach providing high geometric fidelity and data quality preferably at low specific absorption rate and suitable for enhanced multiple contrast imaging.

This object is achieved by providing an, in particular computer-implemented, method, a magnetic resonance imaging device, a computer program and an electronically readable storage medium according to the independent claims. Advantageous embodiments are described by the dependent claims.

In a herein described method for operating a magnetic resonance imaging device a magnetic resonance sequence is used to, in an acquisition volume of a patient, acquire magnetic resonance data in k-space, wherein the magnetic resonance measurement data is acquired in at least two repetitions, the magnetic resonance sequence comprising, for each repetition:
- a preparation module, comprising at least one tip-down radio frequency pulse and at least one tip-up radio frequency pulse applied a preselected preparation time after the tip-down radio frequency pulse, and
- a readout module.

Herein the tip-down radio frequency pulse is slab-selective by applying a first slab selection gradient pulse in a phase-encoding direction, and the preparation module of at least one of the at least two repetitions prepares the magnetisation in the acquisition volume differently than the preparation module in another of the at least two repetitions.

By preparing the magnetisation differently in different repetitions of the pulse sequence, parameters dependent on the used preparations can be derived. Thus, it is possible to derive multiple parameters after execution of one pulse sequence, e.g. by using a known and easy to implement mono-exponential fitting model. It is also possible to create maps of the according parameters that portray a spatial distribution of the respective parameter and that, when multiple parameters were derived, are already advantageously co-registered which leads to a better comparability of the created maps.

In particular, the preparation module can prepare a T2 weighting in the magnetisation in the acquisition volume. It is also possible that the preparation module prepares a diffusion weighting in the magnetisation in the acquisition volume, wherein the preparation module comprises at least one diffusion gradient pulse group, in particular applied between the tip-down radio frequency pulse and the tip-up radio frequency pulse, to introduce the diffusion weighting to the magnetisation in the acquisition volume.

As usual, the partition encoding direction (usually y) is chosen perpendicular to the phase encoding direction (usually z). The readout direction (frequency encoding direction, usually x) is chosen perpendicular to both the phase encoding direction and the partition encoding direction. As principally known, the three-dimensional k-space to be sampled, in particular the sampling positions, and hence the magnetic resonance magnetisation prepared data in k-space, may be acquired in one single repetition or may be divided into subsets each acquired in one of multiple repetitions (shots). In each repetition, which comprises a preparation module and a readout module, magnetic resonance measurement data is acquired for the whole k-space to be sampled or one subset, e.g. per magnetisation to be prepared. For example, 10 to 100 subsets may be used for one magnetisation preparation, also defining the number of required repetitions for magnetisation preparation. It is noted, that, as usual, multiple magnetic resonance magnetisation prepared data sets may be acquired, e.g. for different T2 weightings and/or for different b values. A b=0 data set may be acquired by leaving out the diffusion gradient pulse group.

It is possible to, at the beginning of the (magnetisation) preparation module, apply a saturation pulse, in particular a fat saturation radio frequency pulse, to saturate the magnetisation of spins which are not of interest, in particular non-water spins (that is, spins of protons not bound in water). Of course, other fat saturation and fat suppression techniques may also be employed.

A diffusion gradient pulse group may comprise at least one diffusion gradient pulse and at least one refocusing, in particular 180°, radio frequency pulse. As further discussed below, the concrete structure of the diffusion gradient pulse group may preferably be chosen to supress artifacts, in particular by supressing eddy currents, reducing spatial distortion and the like, to allow best image quality regarding these aspects.

The tip-down radio frequency pulse preferably has a flip angle of 90° (90° tip-down pulse). It is applied slab selectively, that is, it is output simultaneously with a slab selection gradient pulse in the phase encoding direction. Hence, excitation is restricted spatially to the spins of interest, in particular spins of protons bound in water ("water spins") if fat suppression or saturation has been applied. The field of view is hence reduced in the phase-encoding direction, such that the approach described here may be called a reduced field of view (rFOV) approach. In preferred embodiments, where the readout module is three-dimensional, the readout module may also be slab-selective by applying a second slab selection gradient pulse in a partition encoding direction, which is orthogonal to the phase-encoding direction. Hence, also in the phase encoding direction, the field of view can be reduced. In such a case, of course, the readout module may still comprise phase encoding gradients and respective rewinder gradients in the partition encoding direction in addition to the second slab selection gradient.

The magnetisation preparation module also, as known, comprises at least one tip-up radio frequency pulse that is applied a preselected preparation time after the tip-down radio frequency pulse, e.g., if diffusion weighting is prepared, succeeding the diffusion gradient pulse group. The tip-up radio frequency pulse may correspond to the tip-down radio frequency pulse, in particular at least regarding the flip angle. A slab selectivity for the tip-up radio frequency pulse is not required. Hence, the tip-up radio frequency pulse is preferably non-selective. The tip-up radio frequency pulse may preferably be followed by a spoiler gradient pulse which dephases any remaining transverse magnetisation from spins outside the reduced field of view in order to avoid unwanted signal from outside the reduced field of view.

Reducing the field of view in the phase encoding direction allows to use shorter readout modules, since the number of phase encoding steps in the readout module can be reduced to fit the reduced field of view. For example, half as many or even less than half as many phase encoding steps as used without slab selectivity of the tip-down radio frequency pulse may be required. This allows to reduce the duration of the readout module, thereby reducing T1 contamination and increasing the prepared weighting, e.g., if diffusion weighting is prepared, increasing relative diffusion weighting. This is especially advantageous for three-dimensional readout modules but can also be applied to two-dimensional readout modules. In preferred embodiments, the readout module may be a gradient echo (GRE) readout module. In this manner, the advantages of the gradient echo readout, in particular its low SAR, may be utilized.

In summary, the preparation module is combined with a two-dimensional or, preferably, three-dimensional readout module, wherein the tip-down radio frequency pulse of the preparation module is applied simultaneously with a slab-selective gradient (of the slab selection gradient pulse) in the phase-encoding direction, thereby restricting excitation to a reduced field of view, namely the slab, in this direction, and hence allowing for a reduced readout time which results in lower T1 contamination and higher relative prepared weighting of the magnetisation in the acquisition volume. The magnetic resonance sequence described here can be understood as an, in particular three-dimensional, reduced field of view magnetisation-prepared magnetic resonance imaging sequence.

In preferred embodiments, the readout module uses a centric encoding scheme in the phase-encoding direction, in particular starting at the central k-space line in the phase-encoding direction. Hence, the most central k-space line, where most of the signal is found, is acquired first, such that its magnetic resonance measurement data has the most prepared weighting and is least affected by possible T1 contamination. Thus further improving measurement data quality. In particular, Cartesian sampling may be used. For example, for each repetition, an excitation radio frequency pulse may be played out, in particular during respective second slabselection gradient pulses in the partition encoding direction. The excitation radio frequency pulse may be followed by pairs of phase encoding gradient pulses and phase rewinder gradient pulses both for the phase encoding direction and the partition encoding direction. A readout gradient pulse is output in a readout direction perpendicular to both the phase encoding direction and the partition encoding direction between the respective phase encoders and rewinders.

As already discussed, a tip-up radio frequency pulse is used following the tip-down radio frequency pulse, and, if applicable, a diffusion gradient group in the preparation module. The tip-up radio frequency pulse may be preceded by a magnetisation stabilizer gradient pulse, in particular in the partition encoding direction, of the magnetisation preparation module. Then the readout module may comprise a respective stabilizer rewinding gradient pulse in the stabilization direction output after each excitation radio frequency pulse of the readout module. Such a stabilizer rewinding gradient pulse would in particular have opposing polarity regarding the magnetisation stabilizer gradient pulse. Magnitude stabilization techniques are known in the art for other applications and solve the problem of unknown phases of the transverse magnetisation before applying a radio frequency pulse, in this case the tip-up radio frequency pulse. Depending on the phase position, the radio frequency pulse may affect all from no magnetisation to the whole magnetisation. By dephasing the spins using the magnetisation stabilizer gradient, at least half of the spins are reliably affected, leading to magnitude stabilization. However, to prevent phase-induced magnitude inconsistencies, that would normally occur after the diffusion preparation module and keep them as inconsistencies of the phase (phase inconsistencies), the stabilizer rewinding gradient pulses may be applied during the readout module for each excitation radio frequency pulse. Such stabilizer rewinding gradient pulses additionally act as spoiler gradients for the magnetisation in the outer volume, that is, outside the slab, supressing unwanted signals. In concrete embodiments, the magnitude stabilizer gradient pulse may be output shortly before the tip-up radio frequency pulse, e.g., if applicable, following a diffusion gradient pulse group.

In principle, the magnitude stabilizer gradient pulse can be output in any direction. Preferably, the magnitude stabilizer gradient pulse is output in the partition encoding direction and the stabilizer rewinding gradient pulse is included in a phase encoding gradient pulse in the partition encoding direction associated with the excitation radio frequency pulse. For example, the partition stabilizer rewinding gradient can be incorporated into the phase encoding gradient as an additional moment, corresponding to the moment of the magnitude stabilizer gradient pulse. In this manner, no additional gradient pulse is required.

As already noted, a spoiler gradient pulse may be applied, for example in the partition encoding direction, between the tip-up radio frequency pulse and the readout module. Such a spoiler gradient pulse acts to dephase any remaining transverse magnetisation, including in the outer volume and/or of non-water spins, for example those of protons bound in fat.

In possible embodiments, at least one readout module, maybe even each readout module, comprises, at its end, a phase navigator submodule for measuring phase information associated with the respective repetition, wherein the phase information is used to correct the acquired magnetic resonance measurement data regarding phase offsets between repetitions.

Here, if a magnetisation stabilizer gradient pulse is used, the stabilizer rewinding gradient pulse may also applied in the phase navigator submodule. Hence, a phase navigator (or phase correction navigator) can be used to keep track of phase information and correct any inter-repetition (inter-shot) phase offsets. The phase information measured may be two-dimensional, in particular comprising the k-space centre. A two-dimensional phase navigator can quickly be measured and, in particular if placed in the k-space centre, yields all required information in evaluable form. The two-dimensional phase navigator may preferably be linearly encoded. The phase information may be repetition-wise applied to correct phase offsets between repetitions. The phase information may be determined for each receiving coil element by applying an inverse Fourier transform to the navigator data set acquired in a respective repetition. A Hamming filter may then be applied to the transformed navigator data set to reduce Gibbs ringing in the phase navigator from which the phase information is determined. To correct any phase offsets, an inverse Fourier transform may be applied to the magnetic resonance measurement data subset of the respective repetition and receiving coil element. The phase information may be applied as a correction to the transformed subset. To transform the corrected data back into k-space, a Fourier transform may be applied to the corrected subset. All corrected magnetic resonance diffusion data subsets for each receiving coil element and repetition then may form the corrected magnetic resonance measurement data set, from which, for example, a T2 weighted image, a T2 map, a diffusion weighted image, a diffusion coefficient map and the like could be reconstructed in a known manner according to the magnetisation preparations applied in the repetitions of the sequence.

The slab dimension in the phase encoding direction may be chosen to cover a whole region of interest of the acquisition volume. Hence, only one slab has to be acquired. It is, however, also conceivable to define two or more slabs covering the region of interest and acquire their respective magnetic resonance diffusion data in successive imaging processes, each using the magnetic resonance sequence as described above with accordingly chosen slab selection gradient pulses. If a reduced field of view is also used in the partition encoding direction, the slab dimension in the partition encoding direction may also be chosen to cover the whole region of interest of the acquisition volume.

Regarding an application of a diffusion gradient group, many known concrete configurations may be employed. Diffusion gradient groups have been optimized in the art, in particular regarding eddy currents and reduction of spatial distortion artifacts. For example, bipolar diffusion gradient pulses may be used, and twice-refocused techniques may be applied. For example, a bipolar twice-refocused diffusion preparation may be used, significantly reducing spatial distortion artifacts and hence further improving spatial accuracy. In such embodiments, the diffusion gradient group may comprise a pair of bipolar diffusion gradient pulses, each surrounding a 180° adiabatic refocusing radio frequency pulse. The refocusing radio frequency pulse may be output between the two sub-pulses of opposite polarity of the bipolar diffusion gradient pulse, in particular at zero gradient strength of the bipolar diffusion gradient pulse. However, as mentioned, other diffusion preparation techniques may also be employed.

The combination of slab-selectivity in the phase encoding direction, allowing shorter gradient echo readout modules, with magnitude stabilization, a phase navigator and different magnetisation preparation schemes synergize to allow a magnetisation prepared magnetic resonance measurement with especially high overall data quality, and, in particular, high geometric fidelity and accuracy even for multiple different magnetisation preparations. If a gradient echo readout is used, a low SAR may also be achieved.

The invention also concerns a magnetic resonance imaging device, comprising a control device having an acquisition unit, wherein the acquisition unit is configured, for magnetisation prepared imaging in an acquisition volume of a patient, to use a magnetic resonance sequence to acquire magnetic resonance measurement data in k-space in at least two repetitions as described herein. All remarks and features regarding the described method can analogously be applied to the magnetic resonance imaging device configured to perform the method and vice versa, such that the same advantages may be achieved.

The control device may comprise at least one processor and at least one storage means. Functional units may be implemented by hardware and/or software, comprising an acquisition unit to control acquisition equipment of the magnetic resonance imaging device to acquire magnetic resonance data, in particular magnetic resonance measurement data using the magnetic resonance sequence as described above. In particular, the magnetic resonance imaging device may comprise a main magnet unit comprising a main magnet, which generates a main magnetic field in a bore of the main magnet unit. The acquisition equipment may comprise at least one gradient coil assembly to output gradient pulses and at least one radio frequency coil assembly to output radio frequency pulses and/or receive magnetic resonance signals. At least one radio frequency coil assembly may comprise multiple coil elements, which may be used independently for transmitting and/or receiving.

A computer program according to the invention comprises program means such that, when the computer program is executed on a control device of a magnetic resonance imaging device, the control device is caused to perform a method according to the invention. The computer program may be stored on an electronically readable storage medium according to the invention, which hence comprises control information stored thereon, which comprises a computer program according to the invention and is configured such that, when the storage medium is used in a control device of a magnetic resonance imaging device, the control device is configured to perform a method according to the invention. The electronically readable storage medium may be a non-transitory medium, for example a CD ROM.

Other objects and features of the present invention will become apparent from the following detailed description considered in conjunction with the accompanying drawings. The drawings, however, are only principle sketches designed solely for the purpose of illustration and do not limit the invention. The drawings show:
- Fig. 1: a sequence diagram of a magnetic resonance sequence with exemplary possible preparation modules that could be used in a method according to the invention,
- Fig. 2: a flowchart of a method according to the invention, and
- Fig. 3: a magnetic resonance imaging device according to the invention.

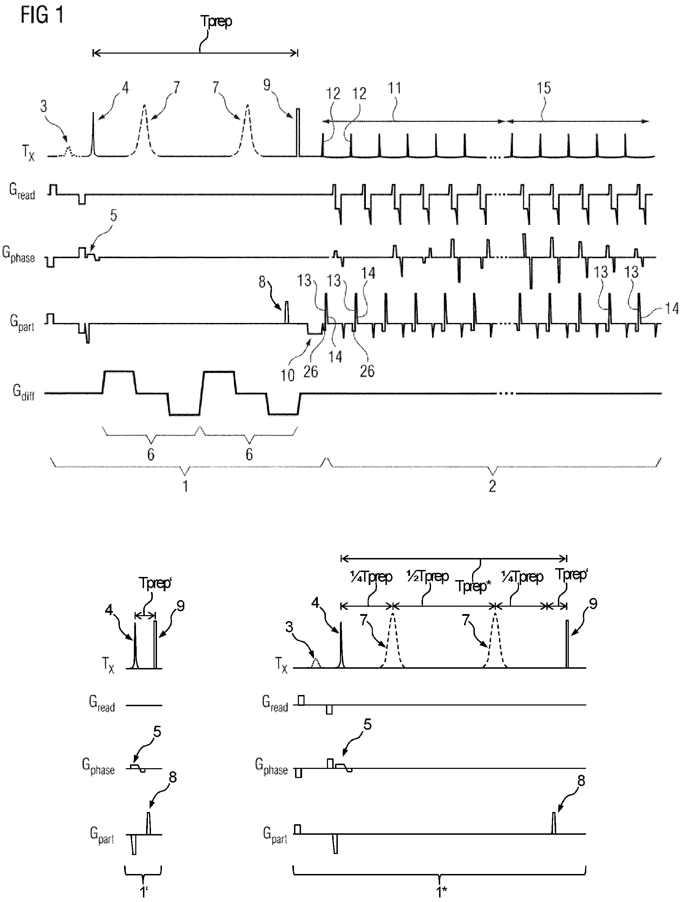

Fig. 1 shows a sequence diagram of one repetition (top) of an exemplary magnetic resonance sequence that could be used in a method according to the invention. Alternative examples for preparation modules (1, 1*) are shown below. In each example the uppermost graph shows radiofrequency activity (Tx), the next gradient activity in a readout direction (G_{read}), the middle graph gradient activity in a phase encoding direction (Pₚₕₐₛₑ), the next-to-lowest graph gradient activity in a partition encoding direction (Gₚₐᵣₜ) and the final graph possible diffusion gradient activity (G_{diff}). In the following, not all radio frequency pulses and gradient pulses will be discussed in detail, but the focus will be on the relevant design regarding optimized magnetisation prepared data quality, in particular regarding geometric fidelity and accuracy, while minimizing SAR and T1 contamination and maximizing a prepared weighting.

In a possible example, the used magnetic resonance imaging device provides a main magnetic field of 3T or more. If a diffusion preparation is induced, the magnetic resonance sequence could use a twice-refocused bipolar diffusion preparation scheme combined with a gradient echo readout, followed by a two-dimensional phase correction navigator.

In each repetition, as shown in Fig. 1, a subset of the k-space to be acquired may be threedimensionally measured using respective encoding, in particular phase encoding steps. For example, 10 to 100 encodings and hence repetitions can be used for one type of preparation.

Each repetition, as shown in Fig. 1, comprises a preparation module 1, 1', 1* and a readout module 2. At the beginning of the preparation module, a fat saturation radio frequency pulse 3 (accompanied by respective gradient pulses) may be applied as shown to saturate fat spins, such that the signal of water can be reliably measured by receiving signals from water spins.

If applied, immediately after the fat saturation radio frequency pulse 3, a 90° tip-down radio frequency pulse 4 is output simultaneously with a slab selection gradient pulse 5, such that the 90° tip-down radio frequency pulse 4 only acts on a certain slab, which, in this case, covers the whole region of interest, that is, the relevant acquisition volume, in the phase encoding direction. Hence, by slab selectivity, a reduced field of view is excited. A possible diffusion preparation group following the excitation may comprise a pair of bipolar diffusion gradient pulses 6, each surrounding a 180° adiabatic refocusing radio frequency pulse 7 as shown. A tip-up radio frequency pulse 9 is applied a preselected preparation time Tprep after the tip-down radio frequency pulse 4. The preparation time Tprep will allow a certain decay of the transversal magnetisation T2, and thus may prepare a T2 weighting, because the readout module 2, in which measurement data will be acquired will only start after the tip-up radio frequency pulse 9, the time Tprep after the excitation by the tip-down radio frequency pulse 4.

At least one magnitude stabilizer gradient pulse 8 is applied in the partition encoding direction directly before a non-selective tip-up radio frequency pulse 9 to fully dephase spins across the selected slab. Following the tip-up radio frequency pulse 9, in the shown embodiment, a spoiler gradient pulse 10 is applied to dephase any remaining transverse magnetisation, including in the outer volume (outside the selected slab) and/or fat spins.

The readout module 2 comprises gradient echo readout submodules in a first time interval 11 for each k-space phase encoding line to be acquired, wherein centric encoding may be used regarding the order of the phase encoding lines. A magnitude stabilizer rewinder gradient pulse is played out after each excitation radio frequency pulse 12, thereby reverting phase-induced magnitude inconsistencies back into phase inconsistencies. In the shown embodiment, the stabilizer rewinder gradient pulse is incorporated as additional moment 13 into phase encoding gradient pulses 14. Also in this embodiment, with each excitation radio frequency pulse 12, second slab selection gradient pulses 26 are output, which provide slab-selectivity also in the partition encoding direction. Due to the centric encoding, most of the signal is acquired with maximized prepared weighting and almost no T1 contamination. The gradient echo readout is shortened compared to a non-slab-selective excitation, further preventing T1 contamination, yet still covering the required range in phase-encoding direction.

After the first time interval 11, in a second time interval 15 of the readout module 2, a phase correction navigator, in particular a two-dimensional phase correction navigator, may be acquired in a phase navigator submodule as shown. Here the stabilizer rewinder gradient pulses may still be applied to revert phase-inconsistencies also for navigator data. Phase information determined from phase navigator data sets for partitions and each receiving coil element can then be used to correct the respective magnetic resonance measurement data subsets of the respective partition and receiving coil element. An inverse Fourier transform may be applied to each phase navigator data set, followed by a Hamming filter to determine phase information, in a known manner. An inverse Fourier transform may then be applied to each magnetic resonance measurement data subset, followed by a phase correction using the phase information for each receiving coil element. A Fourier transform may then be applied to the corrected magnetic resonance measurement data subset. In this manner, inter-repetition phase inconsistencies are corrected.

At least two repetitions are executed with a preparation module 1, 1', 1* followed by a readout module 2, and at least one of the at least two repetitions prepares the magnetisation in the acquisition volume differently than the preparation module in another of the at least two repetitions. By choosing appropriate preparation times Tprep different T2 weightings can be prepared. In the example given in Fig. 1 (below, left), shows a preparation module 1' in which a minimal preparation time Tprep' is preselected as the preparation time Tprep. The minimal preparation time Tprep' is the shortest possible time between the tip-down radio frequency pulse 4 and the tip-up radio frequency pulse 9 that can be achieved. The minimal preparation time Tprep', therefore, may depend on gradients to be applied between the tip-down radio frequency pulse 4 and the tip-down radio frequency pulse 9, in particular the stabilizer gradient 8, and the hardware of the magnetic resonance imaging device used. For a typical T2 mapping a 'zero preparation time' repetition, i.e. a repetition with no preparation time or no preparation module, is performed as a starting point. However, for the proposed pulse sequence, to maintain a reduced FOV approach, the minimal preparation time Tprep' is recommended. This introduces only a minimal degree of T2 weighting to the prepared thus magnetisation.

In the example shown in Fig. 1 (below, right) a preparation module 1* with a preselected preparation time Tprep, that is distributed between the shown adiabatic refocusing radio frequency pulses 7, and that is longer than the minimal preparation time Tprep' is adapted into an adapted preparation time Tprep* by adding the minimal preparation time Tprep' to the preselected preparation time Tprep. The adapted preparation time Tprep* takes the minimal T2 weighting introduced by the minimal preparation time Tprep' into account so that a determination of a corresponding T2 map is simplified. The preparation module 1* as well as the preparation module 1 can be described as twice-refocussed T2 preparation modules because of the exemplarily shown adiabatic radio frequency pulses 7.

When a preparation module 1, 1', 1* comprises at least one diffusion gradient pulse group applied between the tip-down radio frequency pulse 4 and the tip-up radio frequency pulse 9, the preparation module introduces a diffusion weighting to the magnetisation in the acquisition volume. By using different diffusion gradient pulses 6 different diffusion weightings can be prepared.

It is possible to use multiple repetition of the described pulse sequence using all preparation modules 1, 1', 1*, e.g. such that measurement data prepared with different T2 weightings and different diffusion weightings can be acquired by repeating one pulse sequence as described herein. In a particular embodiment, repetitions according to Fig. 1, preparation module 1 or 1* with different preparation times Tprep and (for at least one of the different preparation times Tprep) with different diffusion gradient pulses 6, as well as according to Fig. 1, preparation module 1' with a minimal preparation time Tprep' can be performed to yield measurement data with different T2 weightings and different diffusion weightings.

Hereby, the time between the tip-up radio frequency pulse 9 and the subsequent tip-down radio frequency pulse 4 (of the following repetition) is kept constant during the whole acquisition of measurement data to ensure the initial longitudinal magnetisation is constant and maintain a steady state for all repetitions before the tip-down radio frequency pulse 4 is applied. This can be assured in an easy manner by using the same readout module 2 and, if used at all, the same saturation radio frequency pulse 3 in all repetitions. The excitation radio frequency pulses 12 in the first time interval 11 as well as in the second time interval 15 of the readout module 2 can also be kept the same. When no navigator data is wanted for correction of some magnetic resonance measurement data MD, e.g. for T2-prepared magnetic resonance measurement data, the (navigator) data measured in the second time interval 15 may not be acquired at all, or may be discarded or used as further measurement data, e.g. to increase a resolution of the measurement data. By ensuring that all readout modules 2 in all performed repetitions are structurally the same, i.e. apply the same radio frequency pulses and keep a same time between the tip-up radio frequency pulse 9 and the subsequent tip-down radio frequency pulse 4 of the following repetition the magnetisation for all repetitions is being kept in a consistent steady-state and the data measured in the repetitions thus will be easy to compare or process, in particular when using fitting techniques like mono-exponential fitting.

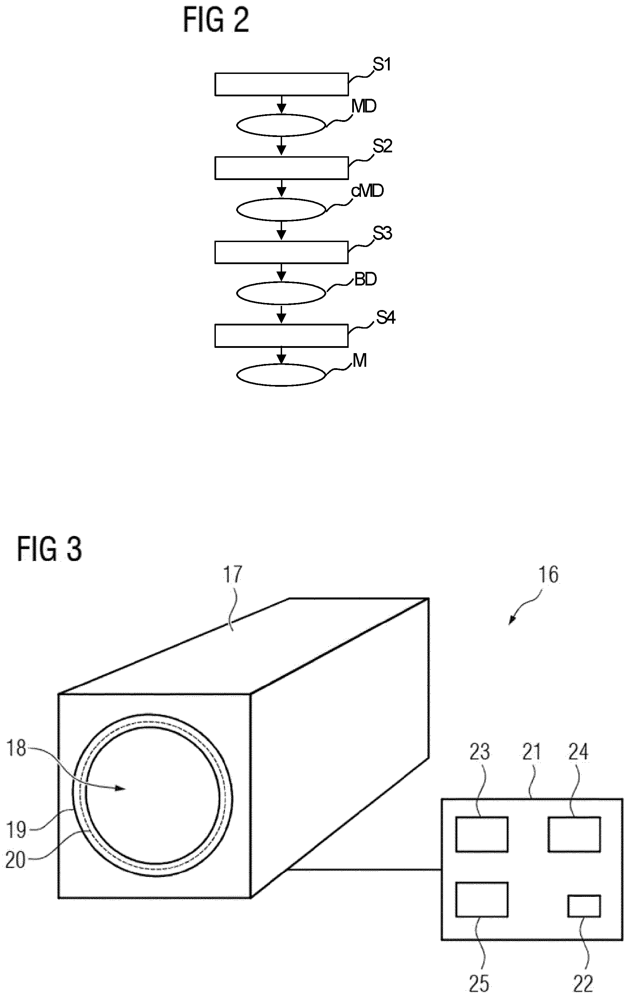

Fig. 2 shows a flowchart of a method according to the invention. In a step S1, magnetic resonance measurement data MD and possibly phase navigator data are acquired using a magnetic resonance sequence of Fig. 1.

In a step S2, correction for phase inconsistencies may be performed using the phase navigator data, if available, to yield corrected magnetic resonance measurement data cMD.

In a step S3, based on the corrected magnetic resonance measurement data cMD or based on the magnetic resonance measurement data MD acquired during readout modules image data BD may be reconstructed. The reconstruction of image data BD could be performed using a known reconstruction technique. The reconstruction of image data BD could also be performed using an LLR (locally low rank) regularization technique. LLR is particularly suitable for reconstructing image data from undersampled measurement data as it leverages redundancies in local image patches across different time points or, e.g. for diffusion data, across different diffusion directions, assuming that these patches can be represented by low-rank matrices as known e.g. by the articles of Trzasko et al. "Local versus Global Low-Rank Promotion in Dynamic MRI Series Reconstruction", Intl. Soc. Magn. Reson. Med. 19: p. 4371, 2011 and of Hu et al. "Multi-shot diffusion-weighted MRI reconstruction with magnitude-based spatial-angular locally low-rank regularization (SPA-LLR)", Magn. Reson. Med. 83; p. 1596-1607, 2020. By enforcing a low-rank constraint, LLR regularization enhances image quality, reduces noise, improves the signal-to-noise ratio (SNR) while preserving fine structural details. Thus, it allows for accelerated imaging by enabling accurate reconstruction from fewer measurements data points. In particular, the LLR regularization may comprise at least two and up to all different b value directions, if a diffusion weighting was prepared, and/or at least two and up to all different preparation times, if different preparation times were used, e.g. to prepare different T2 weightings, in a particular embodiment all different weightings, as prepared in preparation modules used before readout modules the measurement data was acquired with as its low-rank dimension. In contrast to the mentioned work by Hu et al. the reconstruction of image data BD from measurement data (including diffusion data) could be performed here with complex image data as input for the LLR regularization. The image data BD could be reconstructed with an LLR regularization by solving a minimization problem according to the following equation: ${min}_{x} {\sum }_{p = 1}^{P} {\left‖A\left({x}_{p}\right)-{y}_{p}\right‖}_{2}^{2} + {\sum }_{b = 1}^{B} {\left‖{R}_{b}\left({x}_{1},…,{x}_{\left.P\right)}\right.\right‖}_{∗}$ with ${y}_{p} ϵ {ℂ}^{C \times N}$ the k-space measurement data of N sampling points from C coils of the p-th magnetisation preparation module, e.g. different T2-prep durations Tprep or diffusion encoding directions for different b-values, the encoding operator A applying coil sensitivity profiles and Fourier transforms to the corresponding magnetisation prepared image *xₚ* and operator *R_{b}* extracting vectorized 2D kernels with M elements at spatial (pixel) position b stacked along the diffusion encoding direction, repeated for B non-overlapping blocks, and ∥ 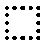 ∥_{*}, denoting the nuclear norm.

In a step S4 at least one map M associated with a weighting introduced by preparation modules of the pulse sequence used is determined based on measurement data acquired during readout modules or based on reconstructed image data. In particular, if T2 weighting was prepared, a T2 map (a spin-spin relaxation map), and/or if diffusion weighting was prepared, a diffusion coefficient map, e.g. an ADC map (ADC, apparent diffusion coefficient), can be determined. Such maps could be determined by using exponential fitting techniques, in particular mono-exponential fitting techniques that are easy to implement.

With the method described herein it is possible to acquire measurement data with preparations for diffusion weighting and for T2 weighting in multiple repetitions of the same pulse sequence. Therefore, image reconstruction as well as determination of maps can be performed using the same techniques for the different weightings. As such the method described enables a 3D distortion-free acquisition of measurement data incorporating both T2 and ADC weightings in a common single pulse sequence.

Fig. 3 schematically shows a magnetic resonance imaging device 16 according to the invention. The magnetic resonance imaging device 16 comprises a main magnet unit 17 housing a main field magnet (not shown), preferably generating a main magnetic field of 3T or more. The main magnet unit comprises a bore 18, into which a patient can be introduced using a patient table (not shown). Surrounding the bore, a gradient coil assembly 19 and a radio frequency coil assembly 20 are indicated. Local coils may, of course, also be used.

The operation of the magnetic resonance imaging device 16 is controlled by a control device 21, whose functional structure is indicated. The control device 21 comprises a storage means 22 for storing data, for example magnetic resonance measurement data and phase navigator data. An acquisition unit 23 controls the acquisition equipment comprising coil assemblies 19, 20 to output pulses according to magnetic resonance sequences, in particular also the one shown in Fig. 1 for magnetic resonance imaging according to step S1. In a correction unit 24, the correction according to step S2 may be applied. The control device 21 further comprises a reconstruction unit 25 for reconstructing magnetic resonance images and maps, in particular according to steps S3 and S4.

Independent of the grammatical term usage, individuals with male, female or other gender identities are included within the term.

## Claims

1. Method for operating a magnetic resonance imaging device (16), wherein, in an acquisition volume of a patient, a magnetic resonance sequence is used to acquire magnetic resonance data in k-space, wherein the magnetic resonance measurement data is acquired in at least two repetitions, the magnetic resonance sequence comprising, for each repetition:
- a preparation module (1, 1', 1*), comprising at least one tip-down radio frequency pulse (4), at least one tip-up radio frequency pulse (9) applied a preselected preparation time (Tprep, Tprep', Tprep*) after the tip-down radio frequency pulse (4),
- a readout module (2),
wherein the tip-down radio frequency pulse (4) is slab-selective by applying a first slab selection gradient pulse (5) in a phase-encoding direction, and
wherein the preparation module (1, 1', 1*) of at least one of the at least two repetitions prepares the magnetisation in the acquisition volume differently than the preparation module (1, 1', 1*) in another of the at least two repetitions.

2. Method according to claim 1, wherein the preparation module (1, 1', 1*) prepares a T2 weighting.

3. Method according to one of the preceding claims, wherein in at least one of the at least two repetitions a minimal preparation time (Tprep') is preselected.

4. Method according to claim 3, wherein a preselected preparation time (Tprep) that is longer than the minimal preparation time (Tprep') is adapted into an adapted preparation time (Tprep*) by adding the minimal preparation time (Tprep') to the preselected preparation time (Tprep).

5. Method according to one of the preceding claims, wherein at least one magnetisation stabilizer gradient pulse (8) is applied between the tip-down radio frequency pulse (4) and the tip-up radio frequency pulse (9).

6. Method according to claim 5, wherein the minimal preparation time (Tprep') is dependent on the at least one magnetisation stabilizer gradient pulse (8) applied between the tip-down radio frequency pulse (4) and the tip-up radio frequency pulse (9).

7. Method according to one of the preceding claims, wherein the preparation module (1, 1', 1*) comprises at least one diffusion gradient pulse group applied between the tip-down radio frequency pulse (4) and the tip-up radio frequency pulse (9) to introduce a diffusion weighting to the magnetisation in the acquisition volume.

8. Method according to one of the preceding claims, wherein a time between the tip-up radio frequency pulse (9) and the subsequent tip-down radio frequency pulse (4) is kept constant during the whole acquisition of measurement data.

9. Method according to one of the preceding claims, wherein at least one map (M) associated with a weighting introduced by preparation modules (1, 1', 1*) is determined based on measurement data (MD) acquired during readout modules (2).

10. Method according to claim 9, wherein an ADC (apparent diffusion coefficient) map and/or a spin-spin relaxation map is determined.

11. Method according to one of the preceding claims, wherein image data (BD) is reconstructed based on measurement data (MD) acquired during readout modules (2) using an LLR (locally low rank) regularization.

12. Method according to claim 11, wherein the LLR regularization comprises b value directions and different preparation times prepared in preparation modules (1, 1', 1*) used before readout modules (2) the measurement data (MD) was acquired with as its low-rank dimension.

13. Magnetic resonance imaging device (16), comprising a control device (21) having an acquisition unit (23), wherein the acquisition unit (23) is configured to use a magnetic resonance sequence to acquire magnetic resonance measurement data in k-space in at least two repetitions according to one of the claims 1 to 12.

14. Computer program, which, when it is executed in a control device (21) of a magnetic resonance imaging device (16), causes the control device (21) to perform the steps of a method according to one of the claims 1 to 12.

15. Electronically readable storage medium, on which a computer program according to claim 14 is stored.
